# EUROPEAN PATENT SPECIFICATION

(11) **EP 4 369 377 B1**
(45) Date of publication and mention of the grant of the patent: **25.12.2024**
(21) Application number: 22206909.8
(22) Date of filing: 11.11.2022
(51) Int. Cl.: H01J 37/32, A61B 18/12

(54) **RADIO FREQUENCY GENERATOR**
RADIOFREQUENZGENERATOR
GÉNÉRATEUR DE RADIOFRÉQUENCES

(43) Date of publication of application: 15.05.2024
(73) Proprietor: Comet AG, 3175 Flamatt (CH)
(72) Inventor: Dennler, Philippe, 3203 Mühleberg (CH); Grede, André, 3018 Bern (CH); Gruner, Daniel, 79410 Badenweiler (DE); Guinnard, Cyril, 1373 Chavornay (CH); Labanc, Anton, 79238 Ehrenkirchen (DE); Sistemich, Roland, 52146 Würselen (DE); Vogel, Samuel, 3018 Bern (CH)
(74) Representative: dompatent von Kreisler Selting Werner - Partnerschaft von Patent- und Rechtsanwälten mbB

(56) References cited:
- EP-A1- 3 745 835
- US-A- 5 332 979
- US-A1- 2003 142 513
- US-A1- 2014 232 483
- US-A1- 2020 395 901

## Description

The present invention relates to a radio frequency (RF) generator in particular for a plasma application.

Plasma processing is a very versatile and precise technique to modify the surfaces of materials, in particular in the manufacturing of semiconductor chips. In plasma processing systems, RF power signals are used to excite gaseous compounds such that free electrons and ions are formed. Depending on a variety of process parameters, the plasma composition, i. e. the amount of ions, electrons, neutrals, and various radicals can be controlled precisely. Such plasma processes are used multiple times in semiconductor production, preferably for the deposition of layers onto a semiconductor wafer or for etching the surface of a semiconductor wafer, both with high uniformity and very precisely over the entire surface.

Plasma process tools are typically operated with RF power signals at frequencies in the range from 0.3 MHz to 300 MHz and at power levels of 50 W and higher, preferably 500 W and higher.

The use of pulse-mode operation to modulate the envelope of the RF power signal has several advantages, in particular, the amount of power dissipated within the semiconductor wafer over a certain time period can be adjusted such that detrimental effects on the wafer or the involved materials are prevented. In addition, the ratio of the different active species can be varied by the power modulation such that, during the various pulsing stages, different reactive species are dominant. This allows to tailor the chemical processes which occur at the wafer surface.

For an RF generator, pulse-mode operation is challenging. Typical pulse rates are in the range of 1 Hz to 100 kHz, but also up to 1 MHz. In consequence, the output of the RF generator has to be modulated accordingly, for example, a sequence of different power levels has to be adjusted in a repeating pattern. The rapid changes of output power can cause internal fluctuations which affect the stability of the DC power which is provided to all parts of the circuit.

Ideally, the DC supply in an RF generator provides a stable settable voltage for an RF power amplifier (PA) input. In fast pulse-mode operation, the DC power supply is operated at a constant set point and provides power to the PA which generates the carrier signal. The modulation of the output power can be done via the driver circuit as a modulation of the gate voltage of the PA.

The DC voltage (V_{busbar}) is distributed via a rail ("busbar") and feeds the driver circuit and the PAs of the RF generator. Ideally, the output wave form of an RF generator in pulse-mode operation would be an amplified copy of the PA input, i. e. rectangular edges when the power level is changed with very fast rise and fall times.

In reality, a stray impedance is present between the DC power supply and the PAs. When the required output current suddenly changes by the modulation, e. g. during RF turn-on and turn-off, when changing the power level, or periodically in pulse-mode operation, transient voltage excursions and oscillations occur on the DC voltage V_{busbar} at the inputs of driver and PA, generating undesired additional signal modulation, for example reduced rise and fall times, over- and undershoots.

The acceptable tolerances for over- and undershoots and the required rise and fall times for power level changes are typically given by the user of the RF generator. Additional boundary conditions and limits on components may be required to ensure reliable, stable, and safe operation of DC supply and PA.

Therefore, an optimization of the components for stabilizing the RF generator's output to several boundary conditions is required to fulfill the output signal specifications.

The standard solution to avoid V_{busbar} transients on the busbar is the use of banks of electrolyte capacitors with large capacitance such that all voltage fluctuations are completely suppressed. Therein, a total capacitance of more than 1000 µP or even 2000 µP and higher is implemented usually by electrolyte capacitors. Therein, electrolyte capacitors are an easy way to provide such a high capacitance in a relatively compact way.

However, electrolyte capacitors are very sensitive in terms of reliability. To operate them for several years without failure (as is required in semiconductor production) requires that their operating temperature be kept below specified limits which means that cooling is required. Due to the geometrical shape of such capacitors, they cannot be appropriately mounted on a cooling plate, and only air cooling via fans is possible.

Power RF generators above 2 kW are typically water-cooled, and all circuit parts which require cooling are arranged on a cooling plate through which water circulates. For such power generators, the use of electrolyte capacitors would require additional air cooling which comes at additional cost and space consumption. Also, for power levels above 2 kW the required number of electrolyte capacitors can typically only be fit into a full 19-inch (482.6-mm) wide housing, but not into a 19/2-inch (241.3-mm) wide housing, since efficient air cooling requires a certain spacing of the capacitors.

Due to their particularly large capacitance values, electrolyte capacitors can only be replaced by a much larger number of alternative capacitors. Such alternatives have smaller capacitances. However, due to the required large number, they need much more space than electrolyte capacitors of a similar capacitance.

There is therefore a need to avoid the use of electrolyte capacitors banks in RF generators, but at the same time to fit the power RF generator with high output powers into a 19/2-inch (241.3-mm) wide housing.

US 2014/232483 A1 describes a combiner for an RF amplifier comprising wiring and a transmission line transformer.

EP 3 745 835 A1 describes a generator that includes a housing, a high-power circuit including a power amplifier, and a low-power circuit. An air flow guidance plate divides the housing into at least two compartments including a high-power compartment and a low-power compartment. The high-power circuit is disposed within the high-power compartment and the low-power circuit is disposed within the low-power compartment.

US 2020/395901 A1 describes a multi-stage system of a radio frequency (RF) power amplifier. Fluid cooling is incorporated directly into the power amplifier (PA) module design. Therein, a PA module includes a circuit board, RF circuit components, a ground plane, and a cooling plate having one or more cooling channels to receive a cooling fluid. The cooling channels are positioned to dissipate heat from the RF circuit components through the ground plane. The PA module may also include RF bias and power electronics within a housing for the PA module without requiring an external control board or power conversion electronics.

US 5 332 979 A describes a compact RF generator system. US 2003/142513 A1 discloses the use of a a damping circuit, comprising a damping resistor and a damping capacitor, to reduce or eliminate the oscillatory ringing and overshoot that may develop in an output voltage.

Thus, it is an objective of the present invention to provide an RF generator, which overcomes the drawbacks of the prior art.

The problem is solved by a radio frequency (RF) generator according to claim 1.

The present invention provides an RF generator, in particular for plasma applications. The RF generator generates an RF output and comprises at least one cooling element having an upper surface and a lower surface. Therein, the cooling element may be built as cold plate including one or more channels or pipes through which a coolant can flow in order to cool the cold plate. Alternatively, the cooling element may be built as heat sink, which may be cooled by an airstream. Further, the RF generator comprises at least one DC power supply. Preferably the RF generator comprises two or more DC power supplies. Therein, the one or more DC power supplies can be connected to the cooling element and cooled via the cooling element. Alternatively, the DC power supplies may be separated from the cooling element and may be cooled by an independent cooling element, e.g. cooled by an airstream generated by an independent fan.

The RF generator comprises at least one power stage to amplify an RF signal, wherein the power stage is connected to an upper surface of the at least one cooling element. The power stage comprises one or more power amplifiers (PAs). If there is more than one power stage, the RF generator may comprise a power combiner in order to combine the amplified RF signal of the more than one power stages. In addition, or alternatively, each power stage may comprise more than one PA, wherein the amplified RF signal of each PA is combined by a combiner, which may be part of the power stage or an individual component. Therein, due to connecting the at least one power stage to the cooling element the at least one power stage is efficiently cooled by the cooling element.

The RF generator further comprises a driver to supply the PA of the at least one power stage, wherein the driver is connected to the upper surface of the at least one cooling element for cooling the driver.

Therein, the at least one DC power supply is connected by a busbar with the PA and the driver, wherein a DC voltage V_{busbar} is supplied to the PA and the driver via the busbar. The busbar comprises a damping network comprising a plurality of capacitors connected between ground and the busbar and configured to shape transients on V_{busbar}. Thus, by the damping network, transient voltage excursions and oscillations on V_{busbar} can be reduced in order to provide a reliable, stable and safe operation of the DC power supply, PA, and any other component. At the same time, it is possible to meet the requirements with respect to acceptable tolerances for the required rise and fall times for power level changes Preferably, the busbar is at least partially built as PCB connecting the DC power supply with the PA and the driver. More preferably, the busbar is completely provided by a PCB.

Preferably, the busbar is at least partially built as metal bar or stripe. Thus, the busbar may be built as a combination of a PCB and the metal bar or stripe. Therein, the metal bar or stripe may have a width larger than the height of the stripe, preferably by a factor of 10 and more preferably by a factor of 20. In particular, the metal stripe may have a height or thickness of between 0.5 mm and 3 mm and a width of between 15 and 30 mm.

Preferably, the busbar comprises an inductance of 50nH or less and, preferably, 40 nH or less. By these values, the effect of transient voltage excursions and oscillations occurring on the DC voltage V_{busbar} at the inputs of driver and PA can be reduced.

Preferably, the damping network capacitors are built as ceramic capacitors. Ceramic capacitors have the advantage of an increased lifetime compared to electrolyte capacitors or metal film capacitors, thereby also increasing the lifetime of the RF generator and the reliability of operation. In addition, less cooling or no additional cooling may be required for ceramic capacitors due to their thermal endurance.

Preferably, the ceramic capacitors are connected to the cooling element for cooling. Thus, efficient cooling is possible due to use of the ceramic capacitors. Alternatively, if the ceramic capacitors cannot be connected directly to the cooling element, an indirect connection to the cooling element can be implemented. This indirect connection may include an array of vias connecting the solder pads of the ceramic resistors to similar areas on the bottom side of the PCB to which the ceramic capacitors are attached. Thus, thermal losses are spread over a larger area of the PCB. In addition, thermally conductive metal standoffs, spacers, or bolts to which the PCB is screwed may thermally connect specific areas for cooling on the bottom side of the PCB to the cooling element. Alternatively or additionally, convection air cooling might be used to provide cooling.

Preferably, the sum or total capacitance of all capacitors in the damping network is less than 200 µF, preferably less than 100 µF, more preferably less than 50 µF, even more preferably less than 10 µF and most preferably less than 5 µF. In order to provide a compact size of the RF generator and, in particular, to fit the RF generator in a 19/2-inch (241.3-mm) sized housing, it is desirable to reduce the space required by the capacitors of the damping network. At the same time, by reducing the capacitance of the damping network, the current provided by the DC supply can be limited when loading the capacitors of the damping network.

Due to the reduced capacitance of the damping network, the time constant of the LC network of busbar inductance and capacitance of the damping network may be below 10 µs.

Thus, the resonance is shifted to above the pulsing frequency of the RF generator, wherein in the prior art when using capacitors with a total capacitance of 1000 µF or more, the resonance frequency was within the range of the pulsing frequency of the RF generator. For example, for a busbar inductance in the range of 20 nH to 50 nH, and a state-of-the-art damping network with electrolyte capacitors of a total capacitance of 1 to 5 mF, the resonance frequency would be in the range of 10 to 35 kHz, which is within the range of typically used pulse rates of 1 Hz to 100 kHz. In contrast, for the much smaller capacitances in the damping network according to this invention, e. g. 2 to 10 µF, the resonance frequency would be between 220 kHz and 800 kHz, which is much higher than the usual pulse rates.

When the RF power is suddenly changed from one level to another in pulse-mode operation, the time constant for over- and undershoots is derived from the resonance frequency of the busbar inductance and the damping network capacitance. In consequence, for the example above, the state-of-the-art damping network with electrolyte capacitors would have a time constant in the range of 30 to 100 microseconds, whereas the solution according to this invention would have a time constant of 1 to 4 microseconds.

For the electrolyte capacitor solution, such over- and undershoots with long time constant can be compensated by the regulation loop which controls the RF output power. However, this is not possible in all cases depending on the required speed of the regulation. In addition, if the electrolyte capacitors are operated with pulse frequencies in the range of the resonances described above, an increased ripple current results which causes thermal losses and severely impacts the lifetime of the electrolyte capacitors. This is a particular disadvantage of the state-of-the-art solution in an RF generator which is operated in pulse mode compared to the damping network with much smaller capacitances according to this invention.

In the solution according to this invention with strongly reduced capacitance which can be realized by ceramic capacitors, the lifetime issue of electrolyte capacitors is avoided. Due to the short time constant of over- and undershoots, they are always much shorter than the pulse length and in the vicinity of the rising and falling edges of the pulse pattern. The combination of resistances and capacitances of the RC damping network is specifically designed to keep the excursions of over- and undershoots within the specified deviations from the power set value.

Due to the reduced total capacitance of the damping network, the damping network can be realized solely by ceramic capacitors increasing the reliability and lifetime of the RF generator.

Preferably, the one or more capacitors in the damping network comprise a damping resistor or are connected to a damping resistor in series to create an RC combination. Thus, by the damping resistor, damping of transients on V_{busbar} is achieved.

Preferably, two or more damping resistors have different resistance values. Preferably, all damping resistors have different resistance values. Alternatively, all damping resistors have the same resistance value.

Preferably, the capacitors of the damping network comprise different capacitances. Therein, at least two capacitors of the damping network may have a different capacitance or each of the capacitors of the damping network has a different capacitance. Thus, transients on different time scales can be efficiently damped.

Preferably, the damping network comprises RC combinations with different time constants. Thus, the time constants by the combination of the capacitor and the damping resistor are different for at least two RC combinations or are different for each of the RC combination of the damping network. Therein, the RC combinations with decreased capacitance comprise a decreased resistance. In other words, the smaller the capacitance of the capacitor of the RC combination the smaller the resistance of the resistor of the RC combination.

Preferably, the damping network is arranged on a separate PCB, wherein preferably the damping network comprises one PCB for each power stage. Therein, the PCB may be separate from the driver PCB and/or the power stage. Thus, by use of a separate PCB, arrangement of the damping network within the housing of the RF generator is facilitated in order to provide a compact RF generator. In particular, stacking of two or more PCBs in a three-dimensional arrangement, may be used to achieve a compact arrangement which is compatible with a 19/2-inch (241.3-mm) wide housing of the RF generator.

Preferably, the PCB of the damping network is arranged above the power stage. The PCB is thus placed relative to the power stage opposite to the cooling element. In particular, the PCB is placed in a distance from the power stage and connected to the power stage by one or more connectors such as metallic bolts, spacers, or standoffs. Thereby, a compact arrangement of the damping network is achieved and connection with the power stage is facilitated.

Preferably, the DC power supply is connected to the same cooling element as the power stage and/or the driver. Thus, a compact RF generator is built, and the required number of cooling elements may be reduced. Alternatively, the DC power supply is arranged on a separate cooling element. Alternatively, the DC power supply is not connected to any cooling element of the RF generator and may be cooled by an air stream generated by a fan of the DC power supply. Preferably, the DC power supply is arranged at the lower surface of the at least one cooling element.

Preferably, the at least one cooling element comprises an opening to feed the busbar from the lower surface to the upper surface of the cooling element. Preferably, the busbar is connected to the lower surface of the cooling element, wherein an insulating layer is arranged between the busbar and the at least one cooling element. By using an electrically insulating, but thermally conducting layer between the busbar and the at least one cooling element, cooling of the busbar is facilitated.

Preferably, the RF generator comprises more than one DC power supply, wherein all DC power supplies are connected to the same busbar. Thus, by using more than one DC power supply the available output power of the RF generator can be increased.

Preferably, the RF generator generates more than 2 kW RF output and preferably more than 5 kW.

Preferably, the RF generator is arranged inside a housing, wherein the housing has preferably a standardized 19/2-inch (241.3-mm) size or a 19-inch (482.6-mm) size. Thus, a compact built RF generator is provided.

Preferably, the busbar comprises an RF decoupling network, wherein the RF decoupling network comprises one or more capacitors. Therein, the decoupling network acts as a low pass filter. In particular, the capacitors are connected to ground. Preferably, the capacitors have a total, i e. combined, capacitance of less than 1000 nF, preferably less than 500 nF and more preferably less than 250 nF.

Preferably, the driver comprises a MOSFET having a drain-gate-feedback connection, wherein the drain-gate-feedback connection comprises a capacitor in order to suppress or reduce transients of V_{busbar} to the gate. Preferably, the capacitor comprises a capacitance of less than 2000 pF, preferably less than 1000 pF and more preferably less than 100 pF.

Preferably, the PA comprises a MOSFET, in particular built as LDMOS (laterally diffused metal oxide semiconductor) having a drain-gate-feedback connection, wherein the drain-gate-feedback connection comprises a capacitor to reduce transients of V_{busbar} to the gate. In particular, the capacitor has a capacitance of less than 2000 nF, preferably less than 500 nF and more preferably equal to or less than 200 nF.

Preferably, the driver comprises an output network comprising a DC blocking capacitor having a capacitance of preferably less than 10 nF, preferably less than 5 nF and more preferably less than 2 nF.

Therein, the output network may be arranged between the driver and the PA, in particular the gate of the PA MOSFET.

Preferably, the output network of the driver comprises a series RC circuit parallel to the DC blocking capacitor. Therein, the series RC circuit comprises a resistor and a capacitor connected in series. Preferably, the resistor has a resistance between 0.5 kOhm and 1.5 kOhm and the capacitor of the RC circuit has a capacitance between 0.5 nF and 2 nF.

Preferably, the RF output comprises a rise- and fall-time of less than 1.5 µs and preferably less than 1 µs.

Therein, the rise and fall times are defined by a 10% to 90% change of full power up or a 90% to 10% change of full power down, e. g. for a 1000 W to 100 W power change, the time period for going from 910 W to 190 W is below 1.5 µs and preferably below 1 µs.

Preferably, the output RF power deviates from a setpoint within +/- 5%. This means that transient output power over- and undershoots stay within +/- 5% of the set power.

Thus, by the RF generator of the present invention a damping network is used in order to reduce transients on the V_{busbar} voltage provided by the DC power supply due to a stray impedance of the busbar. Therein, the damping network only comprises ceramic capacitors increasing the lifetime of the RF generator.

However, in order to further compensate for the reduced capacitance of the ceramic capacitors, compared for example to electrolyte capacitors, additional measures may be implemented in the RF generator to avoid/reduce transients and their effects on the amplified RF output. Such measures may include one or more of an optimized RF decoupling network, optimized drain-gate-feedback connections in the driver and/or the PA, or an optimized DC blocking capacitor between the driver and the PA. Thus, acceptable tolerances for over- and undershoots and the required rise and fall times for power level changes of the RF generator can be met. Additional boundary conditions and limits on components may be fulfillable to ensure reliable, stable, and safe operation of DC supply and PA.

In the following the present invention is described in more detail with reference to the accompanying figures.

The figures show:
- Figure 1: a schematic representation of an RF generator,
- Figure 2: a detailed representation of an RF generator according to the present invention in top view,
- Figure 3: a side view of the RF generator according to Figure 2,
- Figure 4: a detailed representation of the damping network and
- Figure 5: a schematic RF generator circuit according to the present invention.

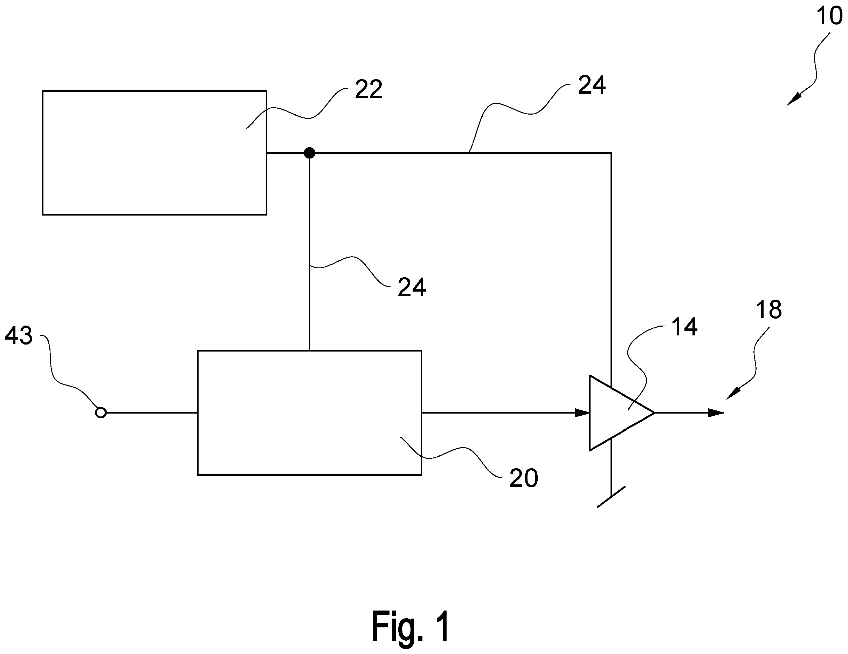

Referring to Figure 1 showing a schematic RF generator 10. The RF generator 10 comprises at least one power amplifier (PA) 14 amplifying an RF signal provided by a driver 20 to generate an amplified version of the RF signal at the output 18 as RF output. The connection 43 may be used to provide an RF modulated input signal to the driver 20. Therein, the driver 20 and the power amplifier 14 are supplied by a DC power supply 22, which is connected to the PA 14 and the driver 20 via a busbar 24. By the busbar 24 a DC voltage V_{busbar} is applied to the PA 14 and the driver 20. Therein, the RF generator 10 according to the present invention is able to provide an amplified RF signal at output 18 with an output power of 2 kW or more, preferably 5 kW or more. The RF signal has a frequency of 0.3 - 300 MHz and in particular 13.56 MHz, 27.12 MHz, 40.68 MHz or 60 MHz. Therein, in pulse-mode operation of the RF generator 10, the envelope of the RF output signal is shaped by changes of the driver output power. Therein, typical pulse rates are in the range of 1 Hz to 100 kHz and might be up to 1 MHz. By this pulse-mode operation, internal fluctuations may occur, which affect the stability of the DC power supply and/or other components of the RF generator. In particular, transients might occur on V_{busbar}, which need to be suppressed.

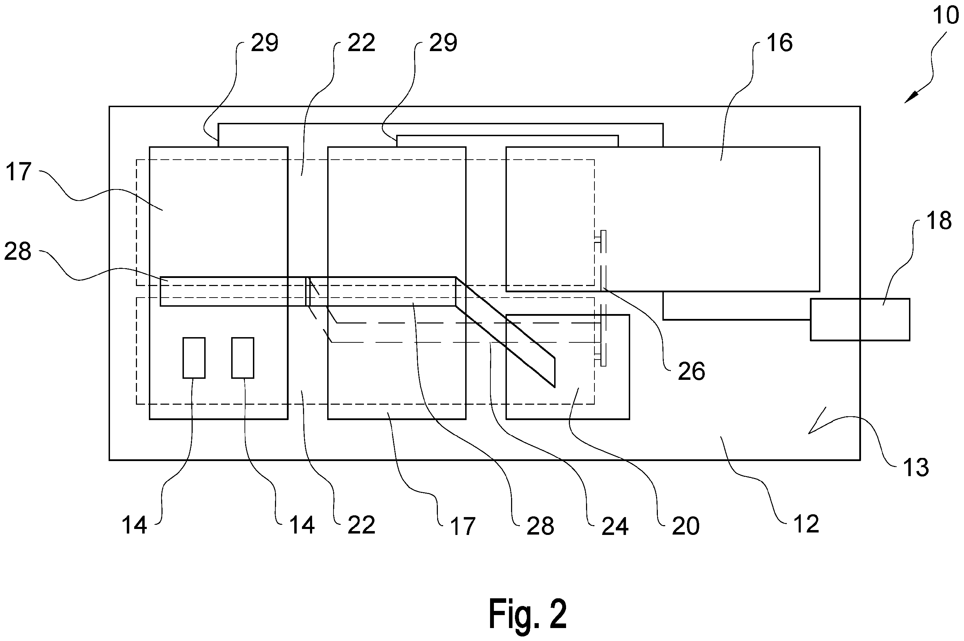

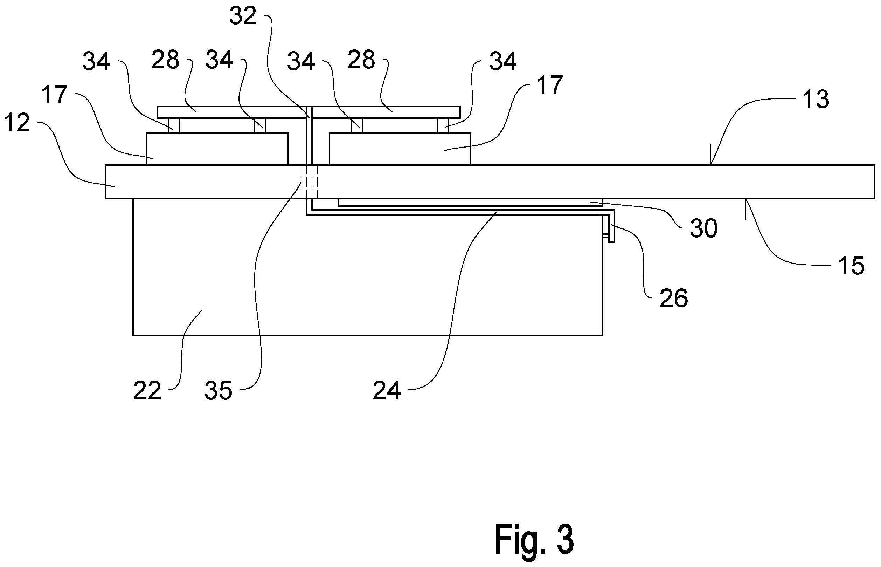

Referring to Figures 2 and 3 showing an RF generator 10 in top view and side view, respectively. In Fig. 2, modules and components with solid-line boundaries are located on or above the upper side of the cooling element 12, whereas modules and components with dashed-line boundaries are located on or below the lower side of the cooling element 12. In the example of Figure 2 the RF generator 10 comprises a cooling element 12 built as cold plate, which might be water cooled or cooled by another coolant flowing through channels within the cooling element 12. As indicated in Fig. 2 and 3, the cooling element 12 comprises an upper surface 13 and a lower surface 15. On the upper surface 13 of the cooling element 12 a driver 20 is arranged. In addition, in the example of Figures 2 and 3, two power stages 17 are arranged to amplify the RF signal from the driver 20. Therein, each power stage 17 may comprise one or more PAs 14, wherein the signals of each PA 14 of one power stage 17 may be combined by a combiner (not shown). The output 29 of each power stage 17 is combined in a power combiner 16 and provided to the output coupler 18.

In the example of Figures 2 and 3, two DC power supplies 22 are arranged at the lower surface 15 of the cooling element 12. The two DC power supplies 22 are connected via a bracket 26 to the busbar 24. Alternatively, in another embodiment there might be more or less DC power supplies and/or the one or more DC power supplies may be at least partially arranged at the upper surface 13 of the cooling element 12. Thus, in the example of Figures 2 and 3, the DC power supplies 22, the power stages 17, the power combiner 16, and the driver 20 share a common cooling element 12. Alternatively, there might be more than one cooling element 12, wherein for example the DC power supplies 22 may be arranged on a separate cooling element. Alternatively, the one or more DC power supplies may not be cooled by a cooling element and may, instead, be cooled by an airstream generated by a fan.

The DC power supplies 22 are connected to the power stages 17 by a busbar 24. In the example of Figures 2 and 3, the busbar 24 is at least partially built as metal stripe or ribbon. The busbar 24 is arranged partially at the lower surface 15 of the cooling element 12 and partially above the upper surface 13 of the cooling element 12 wherein the busbar 24 is routed through an opening 35 in the cooling element from the lower to the upper side of the cooling element. In particular, the busbar 24 is partially arranged between the DC power supply 22 and the lower surface 15 of the cooling element 12. In order to avoid short circuits between the busbar 24 and the cooling element 12, an insulating layer 30 may be arranged between the busbar 24 and the lower surface 15 of the cooling element 12. In order to route the busbar 24 from the lower surface 15 to the upper surface 13 of the cooling element 12, the cooling element 12 may comprise an opening 35 through which the busbar extends towards the upper surface 13 of the cooling element 12. Therein, a substantially vertical section 32 of the busbar 24 extends through the opening 35 and above the power stages 17.

Preferably, the busbar 24 is connected to the individual power stages 17 by a connecting PCB 28. Therein, the connecting PCB 28 is above the power stages 17 and separate therefrom. The connecting PCB 28 is connected to the power stages 17 by connectors 34, e. g. metallic bolts, spacers, or standoffs, to supply the V_{busbar} voltage to the power stages 17, i.e the PAs 14. Therein, in particular for each power stage 17 an individual connecting PCB 28 is implemented.

In an embodiment where the DC power supply 22 is arranged on the upper side 13 of the cooling element 12 or laterally side by side to the upper side 13 of the cooling element 12 (i. e. with the DC output at the same side as the power stages 17, but may be arranged on different cooling elements or without cooling element), the busbar may be implemented without metallic stripe and only by the connecting PCB 28.

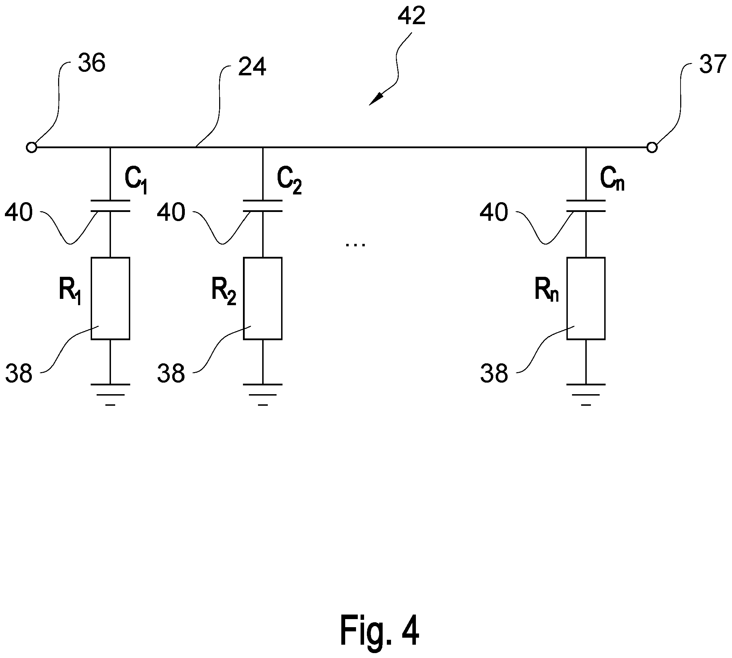

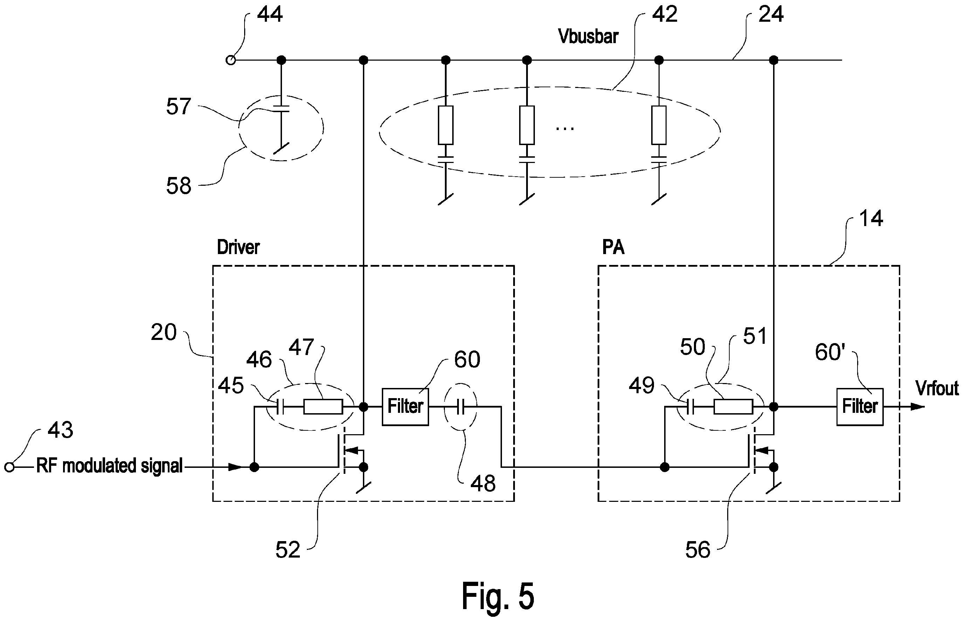

Referring to Figure 5 showing a simplified representation of the circuit of the RF generator 10. Therein, the connection 44 is connected to the one or more DC power supplies 22. The connection 43 may be connected to an RF signal source to provide an RF modulated signal to the driver 20. Connected to the busbar 24 is a damping network 42. The damping network 42 may be arranged on the individual connecting PCBs 28. The damping network 42 is described in more detail with reference to Figure 4. The damping network 42 may be integrated into the busbar 24 by connectors 36 and 37. The damping network 42 comprises a plurality of capacitors 40 having the capacitance C₁, C₂,..., Cᵢ,..., Cₙ. Therein, the sum of the capacitance of all capacitors in the damping network 42, Σ*ᵢ* C*ᵢ*, is less than 200 µF, preferably less than 100 µF and more preferably less than 50 µF.

In particular, all capacitors 40 are built as ceramic capacitors. Therein, ceramic capacitors are more reliable and have an increased lifetime compared to electrolyte capacitors. Usually, it would be intended to increase the capacitance of the damping network 42 in order to suppress transients on the V_{busbar} voltage. With higher capacitance, the required loss to suppress resonances can be decreased. Therefore, the maximum possible capacitance within the available space would be used to keep the heat generated as low as possible. However, such high capacitance could only be achieved with electrolyte capacitors or metal film capacitors, which suffer thermal stress and a reduced lifetime. Thus, by the present invention, it is suggested to implement a reduced capacitance of the damping network 42 and thereby enabling the use of more reliable ceramic capacitors without increase of the space of the RF generator 10. By the reduced capacitance of the capacitors 40 of the damping network 42, the time constant is reduced such that the resonances of the damping network 42 are above the operating frequencies of the RF generator 10. In order to damp transients on the V_{busbar} voltage and suppress over- and undershoots, one or more of the capacitors 40, preferably all of the capacitors 40, are connected in series with damping resistors 38 as depicted in Figure 4. Therein, the damping resistors 38 have the resistance R₁, R₂, ..., Rₙ, respectively.

Therein, for example all capacitances C₁, ..., Cₙ might be the same or different. Similar, all resistances R₁, ..., Rₙ might be the same or different.

In a first example the resistances of the resistors 38 and the capacitances of the capacitors 40 are selected with identical values as follows:

| | | | | |
|---|---|---|---|---|
| R1 | 3,9 Ohm | | C1 | 330 nF |
| R2 | 3,9 Ohm | | C2 | 330 nF |
| R3 | 3,9 Ohm | | C3 | 330 nF |
| R4 | 3,9 Ohm | | C4 | 330 nF |
| R5 | 3,9 Ohm | | C5 | 330 nF |
| R6 | 3,9 Ohm | | C6 | 330 nF |
| R7 | 3,9 Ohm | | C7 | 330 nF |
| R8 | 3,9 Ohm | | C8 | 330 nF |

In another example, the capacitances and the resistances of the capacitors 40 and the resistors 38, respectively, have two different values each. In one example, the resistances and the capacitances are selected as follows:

| | | | | |
|---|---|---|---|---|
| R1 | 1 Ohm | | C1 | 14 nF |
| R2 | 47 Ohm | | C2 | 680 nF |
| R3 | 1 Ohm | | C3 | 14 nF |
| R4 | 47 Ohm | | C4 | 680 nF |
| R5 | 1 Ohm | | C5 | 14 nF |
| R6 | 47 Ohm | | C6 | 680 nF |
| R7 | 1 Ohm | | C7 | 14 nF |
| R8 | 47 Ohm | | C8 | 680 nF |

Thereby, by the different RC combinations, transients on different time scales can be efficiently damped. Therein, in particular the smaller the capacitance of the capacitor 40 of an RC combination, the smaller the resistance of the damping resistor 38 can be selected. In another example, every capacitor and every resistor may have a different value and may be selected as follows:

| | | | | |
|---|---|---|---|---|
| R1 | 1 Ohm | | C1 | 14 nF |
| R2 | 2.7 Ohm | | C2 | 33 nF |
| R3 | 4.7 Ohm | | C3 | 120 nF |
| R4 | 12 Ohm | | C4 | 270 nF |
| R5 | 27 Ohm | | C5 | 390 nF |
| R6 | 33 Ohm | | C6 | 470 nF |
| R7 | 47 Ohm | | C7 | 680 nF |
| R8 | 120 Ohm | | C8 | 820 nF |

Although Figures 4 and 5 show only one capacitor 40 and only one resistor 38 for each RC combination, however, the capacitance as well as the resistance of one RC combination can be composed by a combination of more than one capacitor and/or more than one resistor, respectively. Further, although the tables above indicate a specific number of resistors and their resistances as well as a specific number of capacitors and their capacitances, these are only examples and should not be construed in any limiting way.

Due to implementing the damping network 42 according to Figure 4, efficient damping of transients of the V_{busbar} voltage is feasible with one or more time constants.

By reducing the capacitance of the damping network 42, the required space for the ceramic capacitors is maintained or even reduced in comparison to the use of electrolyte capacitors. Thus, the RF generator can fit into a standardized 19/2-inch (241.3-mm) sized housing or into a 19-inch (482.6-mm) sized housing.

In order to be able to further reduce the effects of transients onto the RF output, the busbar 24 may be connected to an RF decoupling network 58 which is built as low pass filter which has at least one capacitor 57 connected to ground and which, additionally, may comprise a resistor. Therein, the capacitance of the capacitor 57 may be less than 1000 nF, preferably less than 500 nF and more preferably less than 250 nF.

The driver 20 may comprise a MOSFET 52 comprising a drain-gate-feedback connection 46, where the drain-gate-feedback connection 46 comprises at least one capacitor 45. Therein, the capacitor 45 of the drain-gate-feedback connection 46 may have a capacitance of less than 2000 pF, preferably less than 1000 pF and more preferably less than 100 pF.

The capacitor 45 may be combined with a resistor 47. The resistance of the resistor 47 may be less than 10 kOhm preferably less than 5 kOhm and more preferably 2 kOhm or less.

The driver 20 is connected to a PA 14 of the power stage 17, wherein in the connection a DC blocking capacitor 48 is arranged. Therein, the DC blocking capacitor 48 may have a capacitance of less than 10 nF, preferably less than 5 nF, and more preferably less than 2 nF.

The PA 14 comprises a MOSFET 56, preferably built as LDMOS. The MOSFET 56 comprises a drain-gate-feedback connection 51, wherein the drain gate feedback connection 51 may comprise a capacitor 49. Therein, the capacitor 49 of the drain-gate-feedback connection 51 may have a capacitance of less than 1000 nF, preferably less than 500 nF and more preferably equal to or less than 200 nF.

Further, the drain-gate-feedback connection 51 may comprise a resistor 50, wherein the resistor 50 may have a resistance of less than 1 kOhm, II preferably less than 800 Ohm and more preferably less than 600 Ohm.

In the output of the power stage 14 as well as in the output of the driver 20 additional filters 60, 60' may be implemented in order to shape the RF signal. Thus, according to the present invention, in order to use ceramic capacitors 40 in the damping network 42 without increase of the required space, the total capacitance of the damping network 42 is reduced and still sufficiently suppressing transients on the busbar 24 and their effects on the RF output. Additional measures can be implemented to provide an undisturbed RF signal at the output of the RF generator. Therein, a deviation between the generated RF output signal and a set point corresponding to the intended RF signal power of less than +/- 5% can be achieved.

By the solution of the present invention, reliable and more stable operation over a longer lifetime of the RF generator can be achieved. Transient overvoltages at the included MOSFETs are kept within safe operational limits and driver as well as PAs can be operated in a stable operating window.

## Claims

1. Radiofrequency, RF, generator (10), arranged to generate an RF output in particular for a plasma application, comprising:
at least one cooling element (12) having an upper surface (13) and a lower surface (15);
at least one DC power supply (22);
at least one power stage (17) arranged to amplify an RF signal and connected to the upper surface (13) of the at least one cooling element (12), wherein the power stage (17) comprises one or more power amplifiers (14);
a driver (20) arranged to supply the power amplifier (14) of the at least one power stage (17), wherein the driver (20) is connected to the upper surface (13) of the at least one cooling element (12); and
wherein the at least one DC power supply (22) is connected by a busbar (24) with the power amplifier (14) and the driver (20), wherein the at least one DC power supply (22) is arranged to supply a DC voltage V_{busbar} to the power amplifier (14) and the driver (20) via the busbar (24);
**characterized in that**
the busbar (24) comprises a damping network (42) comprising a plurality of capacitors (40) connected between ground and the busbar (24) and configured to shape transients on V_{busbar}.

2. RF generator according to claim 1, further **characterized in that** the damping network capacitors (40) are built as ceramic capacitors.

3. RF generator according to any of claims 1 or 2, further **characterized in that** the sum of the capacitances of all capacitors (40) in the damping network (42) is less than 200 pF, preferably less than 100 µF and more preferably less than 50 µF.

4. RF generator according to any of claims 1 to 3, further **characterized in that** one or more of the capacitors (40) in the damping network (42) comprise a damping resistor (38) or are connected to a damping resistor (38) in series to create an RC combination.

5. RF generator according to claim 4, further **characterized in that** two or more damping resistors (38) have different resistance values.

6. RF generator according to claim 4 or 5, further **characterized in that** the damping network (42) comprises RC combinations with different time constants.

7. RF generator according to any of claims 1 to 6, further **characterized in that** the damping network (42) is arranged on a separate PCB (28), wherein preferably the damping network (42) comprises one PCB (28) for each power stage (17).

8. RF generator according to claim 7, further **characterized in that** the PCB (28) of the damping network (42) is arranged above the power stage (17).

9. RF generator according to any of claims 1 to 8, further **characterized in that** the DC power supply (22) is arranged at the lower surface (15) of the at least one cooling element (12).

10. RF generator according to claim 9, wherein the at least one cooling element (12) comprises an opening (35) to feed the busbar (24) from the lower surface (15) to the upper surface (13).

11. RF generator according to claim 9 or 10, further **characterized in that** the busbar (24) is connected to the lower surface (15) of the at least one cooling element (12), wherein an insulating layer (30) is arranged between the busbar (24) and the at least one cooling element (12).

12. RF generator according to any of claims 1 to 11, arrangeable inside a housing, wherein the housing has preferably a standardized 19/2-inch (241.3-mm) size or a 19-inch (482.6-mm) size.

13. RF generator according to any of claims 1 to 12, further **characterized in that** the busbar (24) comprises an RF decoupling network (58), wherein the RF decoupling network comprises one or more capacitors (57) having a total capacitance of less than 1000 nF, preferably less than 500 nF, and more preferably less than 250 nF.

14. RF generator according to any of claims 1 to 13, further **characterized in that** the driver (20) comprises a MOSFET (52) having a drain-gate-feedback connection (46), wherein the drain-gate-feedback connection (46) comprises a capacitor (45) having a capacitance of less than 2000 pF, preferably less than 1000 pF and more preferably less than 100 PF.

15. RF generator according to any of claims 1 to 14, further **characterized in that** the power amplifier (14) comprises a MOSFET (56), preferably an LDMOS, having a drain-gate-feedback connection (51), wherein the drain-gate-feedback connection (51) comprises a capacitor (49) having a capacitance of less than 1000 nF, preferably less than 500 nF and more preferably equal to or less than 200 nF.

16. RF generator according to any of claims 1 to 15, further **characterized in that** the driver (20) comprises an output network comprising a DC blocking capacitor (48) having a capacitance of less than 10 nF, preferably less than 5 nF and more preferably less than 2 nF.

17. RF generator according to claim 16, further **characterized in that** the output network comprises a series RC circuit in parallel to the DC blocking capacitor (48), wherein preferably the resistor has a resistance between 0.5 kOhm and 1.5 kOhm and the capacitor of the RC circuit has a capacitance between 0.5 nF and 2 nF.

## Patentansprüche

1. Radiofrequenz-, RF, Generator (10), welcher zum Erzeugen eines RF-Ausgangs insbesondere für eine Plasmaanwendung ausgebildet ist, mit:
mindestens einem Kühlelement (12) mit einer Oberseite (13) und einer Unterseite (15);
mindestens einer Gleichstromversorgung (22);
mindestens einer Leistungsstufe (17), welche zum Verstärken eines RF-Signals ausgebildet ist und mit der Oberseite (13) des mindestens einen Kühlelements (12) verbunden ist, wobei die Leistungsstufe (17) einen oder mehr Leistungsverstärker (14) aufweist;
einem Treiber (20), der zum Versorgen des Leistungsverstärkers (14) der mindestens einen Leistungsstufe (17) ausgebildet ist, wobei der Treiber (20) mit der Oberseite (13) des mindestens einen Kühlelements (12) verbunden ist; und
wobei die mindestens eine Gleichstromversorgung (22) durch eine Stromschiene (24) mit dem Leistungsverstärker (14) und dem Treiber (20) verbunden ist, wobei die mindestens eine Gleichstromversorgung (22) dazu ausgebildet ist, eine Gleichspannung V_{Stromschiene} an den Leistungsverstärker (14) und den Treiber (20) über die Stromschiene (24) zuzuführen;
**dadurch gekennzeichnet,**
**dass** die Stromschiene (24) ein Dämpfungsnetzwerk (42) mit mehreren Kondensatoren (40) aufweist, die zwischen Masse und der Stromschiene (24) verbunden sind und dazu ausgebildet sind, Transienten auf V_{Stromschiene} zu formen.

2. RF-Generator nach Anspruch 1, ferner **dadurch gekennzeichnet, dass** die Dämpfungsnetzwerkkondensatoren (40) als Keramikkondensatoren ausgebildet sind.

3. RF-Generator nach einem der Ansprüche 1 oder 2, ferner **dadurch gekennzeichnet, dass** die Summe der Kapazitäten sämtlicher Kondensatoren (40) in dem Dämpfungsnetzwerk (42) geringer als 200 µF, vorzugsweise geringer als 100 µF und stärker bevorzugt geringer als 50 µF ist.

4. RF-Generator nach einem der Ansprüche 1 bis 3, ferner **dadurch gekennzeichnet, dass** einer oder mehr der Kondensatoren (40) in dem Dämpfungsnetzwerk (42) einen Dämpfungswiderstand (38) aufweisen oder mit einem Dämpfungswiderstand (38) in Reihe verbunden sind, um eine RC-Kombination zu bilden.

5. RF-Generator nach Anspruch 4, ferner **dadurch gekennzeichnet, dass** zwei oder mehr Dämpfungswiderstände (38) unterschiedliche Widerstandswerte aufweisen.

6. RF-Generator nach Anspruch 4 oder 5, ferner **dadurch gekennzeichnet, dass** das Dämpfungsnetzwerk (42) RC-Kombinationen mit unterschiedlichen Zeitkonstanten aufweist.

7. RF-Generator nach einem der Ansprüche 1 bis 6, ferner **dadurch gekennzeichnet, dass** das Dämpfungsnetzwerk (42) auf einer separaten PCB (28) angeordnet ist, wobei das Dämpfungsnetzwerk (42) vorzugsweise eine PCB (28) für jede Leistungsstufe (17) aufweist.

8. RF-Generator nach Anspruch 7, ferner **dadurch gekennzeichnet, dass** die PCB (28) des Dämpfungsnetzwerks (42) über der Leistungsstufe (17) angeordnet ist.

9. RF-Generator nach einem der Ansprüche 1 bis 8, ferner **dadurch gekennzeichnet, dass** die Gleichstromversorgung (22) auf der Unterseite (15) des mindestens einen Kühlelements (12) angeordnet ist.

10. RF-Generator nach Anspruch 9, bei welchem das mindestens eine Kühlelement (12) eine Öffnung (35) aufweist, um die Stromschiene (24) von der Unterseite (15) zur Oberseite (12) hindurchzuführen.

11. RF-Generator nach Anspruch 9 oder 10, ferner **dadurch gekennzeichnet, dass** die Stromschiene (24) mit der Unterseite (15) des mindestens einen Kühlelements (12) verbunden ist, wobei eine Isolierschicht (30) zwischen der Stromschiene (24) und dem mindestens einen Kühlelement (12) angeordnet ist.

12. RF-Generator nach einem der Ansprüche 1 bis 11, anordenbar in einem Gehäuse, wobei das Gehäuse vorzugsweise eine standardisierte Größe von 19/2 Inch (241,3 mm) oder eine Größe von 19 Inch (482,6 mm) aufweist.

13. RF-Generator nach einem der Ansprüche 1 bis 12, ferner **dadurch gekennzeichnet, dass** die Stromschiene (24) ein RF-Entkopplungsnetzwerk (58) aufweist, wobei das RF-Entkopplungsnetzwerk einen oder mehr Widerstände (57) mit einer Gesamtkapazität von weniger als 1000 nF, vorzugsweise weniger als 500 nF, und stärker bevorzugt weniger als 250 nF aufweist.

14. RF-Generator nach einem der Ansprüche 1 bis 13, ferner **dadurch gekennzeichnet, dass** der Treiber (20) einen MOSFET (52) mit einer Drain-Gate-Feedback-Verbindung (46) aufweist, wobei die Drain-Gate-Feedback-Verbindung (46) einen Kondensator (45) mit einer Kapazität von weniger als 2000 pF, vorzugsweise weniger als 1000 pF, und stärker bevorzugt weniger als 100 pF aufweist.

15. RF-Generator nach einem der Ansprüche 1 bis 14, ferner **dadurch gekennzeichnet, dass** der Leistungsverstärker (14) einen MOSFET (56), vorzugsweise einen LDMOS, mit einer Drain-Gate-Feedback-Verbindung (51) aufweist, wobei die Drain-Gate-Feedback-Verbindung (51) einen Kondensator (49) mit einer Kapazität von weniger als 1000 nF, vorzugsweise weniger als 500 nF, und stärker bevorzugt gleich oder weniger 200 nF aufweist.

16. RF-Generator nach einem der Ansprüche 1 bis 15, ferner **dadurch gekennzeichnet, dass** der Treiber (20) ein Ausgangsnetzwerk mit einem Gleichspannungs-Sperrkondensator (48) mit einer Kapazität von weniger als 10 nF, vorzugsweise weniger als 5 nF, und stärker bevorzugt weniger als 2 nF aufweist.

17. RF-Generator nach Anspruch 16, ferner **dadurch gekennzeichnet, dass** das Ausgangsnetzwerk RC-Reihenschaltung parallel zu dem Gleichspannungs-Sperrkondensator (48) aufweist, wobei der Widerstand vorzugsweise einen Widerstand zwischen 0,5 kOhm und 1,5 kOhm aufweist und der Kondensator der RC-Schaltung eine Kapazität zwischen 0,5 nF und 2 nF aufweist.

## Revendications

1. Générateur de radiofréquence, RF (10), agencé pour générer une sortie RF en particulier pour une application de plasma, comprenant :
au moins un élément de refroidissement (12) ayant une surface supérieure (13) et une surface inférieure (15) ;
au moins une alimentation en puissance CC (22) ;
au moins un étage de puissance (17) agencé pour amplifier un signal RF et connecté à la surface supérieure (13) de l'au moins un élément de refroidissement (12), dans lequel l'étage de puissance (17) comprend un ou plusieurs amplificateurs de puissance (14) ;
un circuit de pilotage (20) agencé pour alimenter l'amplificateur de puissance (14) de l'au moins un étage de puissance (17), dans lequel le circuit de pilotage (20) est connecté à la surface supérieure (13) de l'au moins un élément de refroidissement (12) ; et
dans lequel l'au moins une alimentation en puissance CC (22) est connectée par une barre omnibus (24) à l'amplificateur de puissance (14) et au circuit de pilotage (20), dans lequel l'au moins une alimentation en puissance CC (22) est agencée pour alimenter une tension CC V_{busbar} à l'amplificateur de puissance (14) et au circuit de pilotage (20) par l'intermédiaire de la barre omnibus (24) ;
**caractérisé en ce que**
la barre omnibus (24) comprend un réseau d'amortissement (42) comprenant une pluralité de condensateurs (40) connectés entre la terre et la barre omnibus (24) et configurés pour mettre en forme des signaux transitoires sur V_{busbar}.

2. Générateur RF selon la revendication 1, **caractérisé en outre en ce que** les condensateurs (40) de réseau d'amortissement sont construits en tant que condensateurs céramiques.

3. Générateur RF selon l'une quelconque des revendications 1 ou 2, **caractérisé en outre en ce que** la somme des capacités de tous les condensateurs (40) dans le réseau d'amortissement (42) est inférieure à 200 µF, de préférence inférieure à 100 µF et plus préférablement inférieure à 50 µf.

4. Générateur RF selon l'une quelconque des revendications 1 à 3, **caractérisé en outre en ce qu'**un ou plusieurs des condensateurs (40) dans le réseau d'amortissement (42) comprennent une résistance d'amortissement (38) ou sont connectés à une résistance d'amortissement (38) en série pour créer une combinaison RC.

5. Générateur RF selon la revendication 4, **caractérisé en outre en ce que** deux résistances d'amortissement (38) ou plus ont des valeurs de résistance différentes.

6. Générateur RF selon la revendication 4 ou 5, **caractérisé en outre en ce que** le réseau d'amortissement (42) comprend des combinaisons RC avec des constantes de temps différentes.

7. Générateur RF selon l'une quelconque des revendications 1 à 6, **caractérisé en outre en ce que** le réseau d'amortissement (42) est agencé sur une PCB (28) séparée, dans lequel de préférence le réseau d'amortissement (42) comprend une PCB (28) pour chaque étage de puissance (17).

8. Générateur RF selon la revendication 7, **caractérisé en outre en ce que** la PCB (28) du réseau d'amortissement (42) est agencée au-dessus de l'étage de puissance (17).

9. Générateur RF selon l'une quelconque des revendications 1 à 8, **caractérisé en outre en ce que** l'alimentation en puissance CC (22) est agencée au niveau de la surface inférieure (15) de l'au moins un élément de refroidissement (12).

10. Générateur RF selon la revendication 9, dans lequel l'au moins un élément de refroidissement (12) comprend une ouverture (35) pour faire passer la barre omnibus (24) de la surface inférieure (15) à la surface supérieure (13).

11. Générateur RF selon la revendication 9 ou 10, **caractérisé en outre en ce que** la barre omnibus (24) est connectée à la surface inférieure (15) de l'au moins un élément de refroidissement (12), dans lequel une couche isolante (30) est agencée entre la barre omnibus (24) et l'au moins un élément de refroidissement (12).

12. Générateur RF selon l'une quelconque des revendications 1 à 11, pouvant être agencé à l'intérieur d'un logement,
dans lequel le logement a de préférence une taille normalisée de 19/2 pouces (241,3 mm) ou une taille de 19 pouces (482,6 mm).

13. Générateur RF selon l'une quelconque des revendications 1 à 12, **caractérisé en outre en ce que** la barre omnibus (24) comprend un réseau de découplage RF (58), dans lequel le réseau de découplage RF comprend un ou plusieurs condensateurs (57) ayant une capacité totale inférieure à 1000 nF, de préférence inférieure à 500 nF, et plus préférablement inférieure à 250 nF.

14. Générateur RF selon l'une quelconque des revendications 1 à 13, **caractérisé en outre en ce que** le circuit de pilotage (20) comprend un MOSFET (52) ayant une connexion de retour drain-grille (46), dans lequel la connexion de retour drain-grille (46) comprend un condensateur (45) ayant une capacité inférieure à 2000 pF, de préférence inférieure à 1000 pF plus préférablement inférieure à 100 pF.

15. Générateur RF selon l'une quelconque des revendications 1 à 14, **caractérisé en outre en ce que** l'amplificateur de puissance (14) comprend un MOSFET (56), de préférence un LDMOS, ayant une connexion de retour drain-grille (51), dans lequel la connexion de retour drain-grille (51) comprend un condensateur (49) ayant une capacité inférieure à 1000 nF, de préférence inférieure à 500 nF et plus préférablement égale ou inférieure à 200 nF.

16. Générateur RF selon l'une quelconque des revendications 1 à 15, **caractérisé en outre en ce que** le circuit de pilotage (20) comprend un réseau de sortie comprenant un condensateur de blocage CC (48) ayant une capacité inférieure à 10 nF, de préférence inférieure à 5 nF et plus préférablement inférieure à 2 nF.

17. Générateur RF selon la revendication 16, **caractérisé en outre en ce que** le réseau de sortie comprend un circuit RC série en parallèle avec le condensateur de blocage CC (48), dans lequel de préférence la résistance a une résistance comprise entre 0,5 kOhm et 1,5 kOhm et le condensateur du circuit RC a une capacité entre 0,5 nF et 2 nF.
